# EUROPÄISCHE PATENTSCHRIFT

(11) **EP 1 449 255 B1**
(45) Veröffentlichungstag und Bekanntmachung des Hinweises auf die Patenterteilung: **06.12.2006**
(21) Anmeldenummer: 02754516.9
(22) Anmeldetag: 09.08.2002
(51) Int. Cl.: H01L 27/12, G01S 13/93, H01P 7/10

(54) **HOCHFREQUENZ-OSZILLATOR FÜR EINE INTEGRIERTE HALBLEITERSCHALTUNG UND DESSEN VERWENDUNG**
HIGH-FREQUENCY OSCILLATOR FOR AN INTEGRATED SEMICONDUCTOR CIRCUIT AND THE USE THEREOF
OSCILLATEUR HAUTE FREQUENCE POUR UN CIRCUIT INTEGRE SEMI-CONDUCTEUR ET SON UTILISATION

(30) Priorität: 09.11.2001 DE 10156255
(43) Veröffentlichungstag der Anmeldung: 25.08.2004
(73) Patentinhaber: ROBERT BOSCH GMBH, 70442 Stuttgart (DE)
(72) Erfinder: PFIZENMAIER, Heinz, 71540 Murrhardt (DE); HASCH, Juergen, 73066 Uhingen (DE)
(86) Internationale Anmeldenummer: PCT/DE2002/002940
(87) Internationale Veröffentlichungsnummer: WO 2003/041173

(56) Entgegenhaltungen:
- US-A- 4 992 763
- LANGER D: "AN INTEGRATED MMW RADAR SYSTEM FOR OUTDOOR NAGIVATION" PROCEEDINGS OF THE 1996 INTERNATIONAL CONFERENCE ON ROBOTICS AND AUTOMATION. MINNEAPOLIS, APR. 22 - 28, 1996, PROCEEDINGS OF THE INTERNATIONAL CONFERENCE ON ROBOTICS AND AUTOMATION, NEW YORK, IEEE, US, Bd. 1 CONF. 13, 22. April 1996 (1996-04-22), Seiten 417-422, XP000750241 ISBN: 0-7803-2989-9
- LYONS C T ET AL: "A low-cost MMIC based radar sensor for frontal, side or rear automotive anticipatory precrash sensing applications" INTELLIGENT VEHICLES SYMPOSIUM, 2000. IV 2000. PROCEEDINGS OF THE IEEE DEARBORN, MI, USA 3-5 OCT. 2000, PISCATAWAY, NJ, USA,IEEE, US, 3. Oktober 2000 (2000-10-03), Seiten 688-693, XP010529018 ISBN: 0-7803-6363-9
- SATTLER S ET AL: "A coplanar millimeterwave resonator on silicon" MICROWAVE AND MILLIMETER-WAVE MONOLITHIC CIRCUITS SYMPOSIUM, 1993. DIGEST OF PAPERS., IEEE 1993 ATLANTA, GA, USA 14-15 JUNE 1993, NEW YORK, NY, USA,IEEE, US, 14. Juni 1993 (1993-06-14), Seiten 57-60, XP010069107 ISBN: 0-7803-1322-4

## Beschreibung

Die Erfindung betrifft einen Hochfrequenz-Oszillator für eine integrierte Halbleiterschaltung und dessen Verwendung.

### Stand der Technik

Die Halbleitertechnologie findet im zunehmenden Maße Einzug in die Kraftfahrzeugtechnik. Die Miniaturisierung ermöglicht nicht nur eine verbesserte Steuerungs- und Regelungstechnik der motorspezifischen Funktionen, sondern öffnet auch den Weg für neue Sicherheits- und Fahrkomfortsysteme, wie beispielsweise Einparkhilfen, Precrash- und Sidecrash-Funktionen, Toter-Winkel-Erkennung, Füllstandsmessungen und Abstandsmessungen. Für alle steuerungs-und regelungstechnischen Vorgänge muss eine - nach Möglichkeit miniaturisierte - Sensorik im Kraftfahrzeug vorhanden sein.

In der Regel werden für die oben genannten beispielhaften Anwendungsgebiete berührungslose Sensoren verwendet, die einen Messstrahl bestimmter Frequenz emittieren, der an dem zu messenden Objekt reflektiert und mittels einer Empfängereinheit wieder erfasst und ausgewertet wird.

Für Füllstandsmessungen sind Messgeräte im Mikrowellenbereich mit etwa 2 bis 24 GHz, die entweder nach dem FMCW-Prinzip oder als Pulsradar arbeiten, bekannt. Derartige Füllstandssensoren werden für den robusten stationären Gebrauch unter problematischen Umgebungsbedingungen - beispielsweise in Behältern mit brennbaren Stoffen oder bei hohen Umgebungstemperaturen - auf Trägersubstraten wie Teflon oder RT-Duriod realisiert. Des Weiteren bekannt sind Kurzstreckenradarsysteme für Kraftfahrzeuge, die zur Einparkhilfe oder als Precrash-Sensoren dienen und eine Messfrequenz im Bereich von etwa 20 GHz aufweisen.

Für Abstandsmessungen bis zu Reichweiten von 150 m wurden Sensoren mit verschiedenen Lösungsansätzen entwickelt. Sehr kostengünstig, dafür aber aufgrund der geringen Strahlbündelung relativ ungenau, sind Ultraschallgeräte. Wesentlich präziser sind Laserentfernungsmesser, die sich allerdings nicht beliebig miniaturisieren lassen und sehr teuer sind. Weiterhin sind Abstandssensoren bekannt, mit denen Messungen im Mikrowellenbereich durchgeführt werden können. Die dazu notwendigen Sensoren basieren zwar auf Halbleiterschaltungen, jedoch sind die notwendigen Anregungsquellen (Oszillatoren) erst nachträglich durch übliche Hybridtechnik auf der Halbleiterschaltung montiert. Nachteilig hieran ist, dass der Miniaturisierung schon aufgrund der schwierigen Reproduzierbarkeit der Kopplung der Sendeeinheiten an die Halbleiterschaltung Grenzen gesetzt sind. Darüber hinaus müssen die nachträglich auf der Halbleiterschaltung montierten Oszillatoren aufwendig abgeglichen werden. Die Genauigkeit der Messungen hängt unter anderem auch von der Stabilität der Sendefrequenz ab. Zur Frequenzstabilisierung benötigte Referenz-Oszillatoren müssen dann ebenfalls montiert und justiert werden.

Eine nachträgliche Montage der Oszillatoren erfordert weiterhin die Bereitstellung einer aufwendigen Verbindungsarchitektur auf der Halbleiterschaltung, inklusive von Thermoelementen wie Kupferwärmesenken. Eine ungenügende Frequenzstabilität und ein verstärktes Phasenrauschen bei Frequenzen oberhalb von 40 GHz lassen den Einsatz bekannter Oszillatoren in diesem Frequenzbereich wenig geeignet erscheinen.

Ein Hochfrequenz-Oszillator, der sich auf einem Substrat befindet, ist aus US-A-4 992 763 bekannt.

### Vorteile der Erfindung

Die Integration des erfindungsgemäßen Hochfrequenz-Oszillators überwindet die vorgenannten Probleme des Standes der Technik. Der Hochfrequenz-Oszillator zeichnet sich dadurch aus, dass er Bestandteil der Halbleiterschaltung aus einer ersten Siliziumschicht, einer sich anschließenden Siliziumdioxidschicht (Isolierschicht) und einer nachfolgenden weiteren Siliziumschicht (Strukturschicht) ist (SOI-Wafer). Der Hochfrequenz-Oszillator umfasst dabei
(a) einen Resonator mit einem in der Strukturschicht angeordneten, metallisierten Zylinder aus Silizium und einer den Zylinder im Bereich der Schicht überdeckenden Ankopplungsscheibe sowie
(b) eine über eine Ausnehmung der Ankopplungsscheibe mit dem Zylinder des Resonators in Verbindung stehende Impatt-Diode.

Damit steht ein Hochfrequenz-Oszillator mit einer etwa um den Faktor 10 gegenüber bekannten Oszillatoren verbesserten Güte zur Verfügung, der stabile Frequenzen mit geringem Phasenrauschen im Millimeterwellenbereich (80 bis 500 GHz) erzeugt. Die Messung im Mikrowellenbereich ermöglicht eine hohe Strahlbündelung (kleiner ± 5° Halbwertsbreite). Das eingesetzte semiisolierende Siliziummaterial erlaubt die Integration der benötigten planaren Komponenten in Mikrostreifenleiter-Technik auf der in der Umgebung der zylinderförmigen Resonatoren freigeätzten Siliziummembran oder auch in Koplanar-Technik auf dem umgebenden Siliziumbasissubstrat. Alle passiven Komponenten, wie mikromechanisch strukturierte Resonatoren, Schottky-Dioden, Varaktor-Dioden, sowie alle aktiven Komponenten, wie Impatt-Dioden, werden auf dem semiisolierenden SOI-Wafer integriert.

Der Hochfrequenz-Oszillator erzeugt vorzugsweise eine feste Frequenz im Bereich von 80 bis 500 GHz, insbesondere von 100 bis 150 GHz. Die Zylinder des Resonators werden von einer vorzugsweise etwa 1 µm dicken Aluminiumschicht bedeckt, die zur Ausbildung des mit Silizium gefüllten Resonators führt. Gegebenenfalls kann eine weitere Metallschicht, insbesondere Nickelschicht, aufgebracht werden, mittels der ein Löten des Chips möglich wird. Die die Resonatoren überdeckenden Ankopplungsscheiben sind vorzugsweise so dimensioniert, dass an ihrem Rand keine störende Sendeenergie im Mikrowellenbereich austreten kann.

In einer bevorzugten Ausgestaltung ist der Hochfrequenz-Oszillator spannungsgesteuert und eine Varaktor-Diode ist zur Bewerkstelligung der Ansteuerung am Rande der Ankopplungsscheibe implantiert. Die Spannungsversorgung der Impatt-Diode erfolgt vorzugsweise über zwei Tiefpassfilter. Eine Einspeisung der erzeugten Sendeenergie des Hochfrequenz-Oszillators in eine umgebende Mikrostreifenleiter-Schaltung erfolgt über ein Koppelelement.

Der erfindungsgemäße Hochfrequenz-Oszillator findet bevorzugt Einsatz als Bestandteil eines Sensors zur Entfernungsmessung. Der Sensor soll dabei insbesondere im Kraftfahrzeug zur Toten-Winkel-Erkennung, Precrash- und Sidecrash-Erkennung, Abstandsmessung oder als Einparkhilfe genutzt werden.

Weitere vorteilhafte Ausgestaltungen der Erfindung ergeben sich aus den in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figuren 1 bis 3: schematische Schnittansichten durch eine Halbleiterschaltung im Bereich eines Halbleiterbauelementes für Hochfrequenzmessungen in verschiedenen Herstellungsstadien;
- Figur 4: eine perspektivische Seitenansicht auf einen Resonator für einen HochfrequenzOszillator;
- Figur 5: eine schematische Draufsicht auf einen Hochfrequenz-Oszillator;
- Figur 6: einen Querschnitt durch das Halbleiterbauelement im Bereich einer Impatt-Diode;
- Figur 7: einen Verlauf der elektrischen und magnetischen Feldlinien im TE₁₁₁-Mode und
- Figur 8: zwei perspektivische Ansichten auf eine Halbleiterschaltung mit integriertem Hochfrequenz-Oszillator.

### Beschreibung der Ausführungsbeispiele

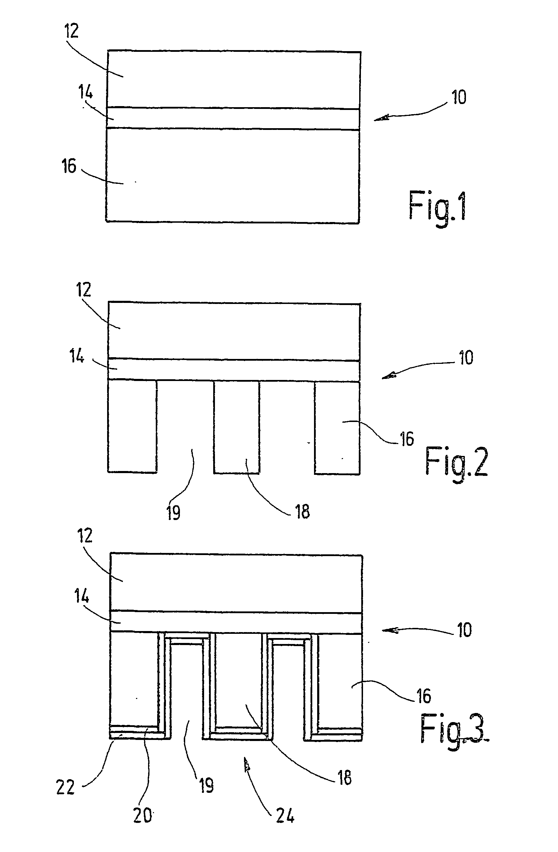

Die Figur 1 zeigt in einer schematischen Schnittansicht einen Ausschnitt aus einem handelsüblichen SOI(Silicon on Insulator)-Wafer, der zur Herstellung einer Halbleiterschaltung 10, die den erfindungsgemäßen Hochfrequenz-Oszillator 30 trägt, dient. Die in Koplanar- oder Planartechnik bekannte Herstellung aller Komponenten der Halbleiterschaltung 10 in einem gemeinsamen Herstellungsschritt wird hier - da allgemein bekannt - nicht näher erläutert. Der Wafer besteht aus einer 675 µm dicken semiisolierenden, p⁻-dotieren Strukturschicht 16 aus Silizium. Sie weist einen spezifischen Widerstand im Bereich von 500 bis 1000 Ωcm, insbesondere 750 Qcm, auf. Die Strukturschicht 16 wird von einer etwa 300 nm dicken Isolierschicht 14 aus Siliziumdioxid bedeckt, auf der eine 50 µm dicke, p⁻-dotierte Schicht 12 aus Silizium aufgebracht ist.

Die Isolierschicht 14 aus Siliziumdioxid dient als Ätzstopp beim Trench-Ätzen der mikromechanischen Strukturen in die Strukturschicht 16. Der Trench-Ätzprozess legt eine Membran, bestehend aus der präzisen 50 µm dicken Schicht 12 und der 300 nm dicken Isolierschicht 14, frei, so dass ein Zylinder 18 aus Silizium stehen bleibt (Figur 2). Der Zylinder 18 wird quasi von einem Freiraum 19 umgriffen.

Die entstandene zylinderförmige Struktur 18 wird durch Bedampfung oder Sputtern mit einer zirka 1 µm dicken Aluminiumschicht 20 überzogen (Figur 3). Der hierdurch metallisierte Zylinder 18 dient als mit semiisolierendem Silizium gefüllter Resonator 24 hoher Güte (Q≈200), der gezielt je nach Anforderungsbedingungen im TE₁₁₁-Mode angeregt werden kann. Zusätzlich kann gegebenenfalls eine Nickelschicht 22 auf die Aluminiumschicht 20 abgeschieden werden. Die Nickelschicht dient als Lötbasis für ein eventuelles Einlöten des den Hochfrequenz-Oszillator aufweisenden Chips (Halbleiterschaltung 10) in ein Gehäuse oder dergleichen.

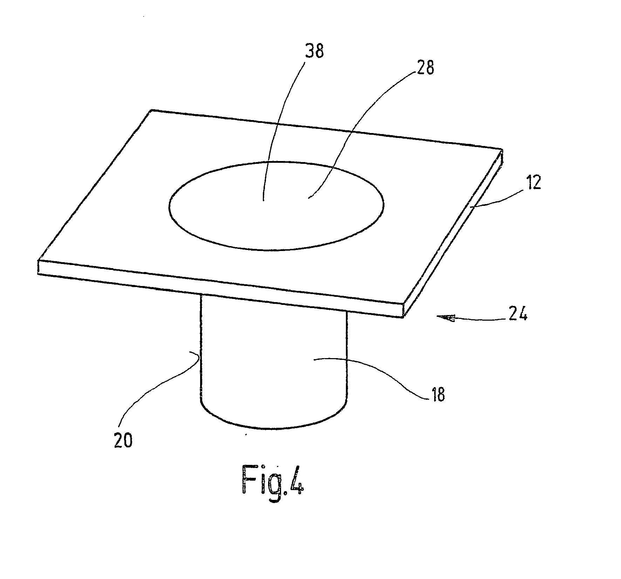

Ein Bereich der Schicht 12 oberhalb des Zylinders 18 wird mit einer Ankopplungsscheibe 28, die über den darunter liegenden Zylinder 18 hinausreicht, bedampft (Figur 4). In der Ankopplungsscheibe 28 ist eine insbesondere als Schlitz ausgebildete Ausnehmung 38 strukturiert. Die Ankopplungsscheibe 28 ist so dimensioniert, dass an deren Rand keine Mikrowellenenergie austreten kann, das heißt, ein Durchmesser der Ankopplungsscheibe 28 ist größer als ein Durchmesser des Zylinders 18. Der Resonator 24 eignet sich - mit geeigneter Spannungsversorgung - als Sender. Der Resonator 24 für einen noch näher erläuterten Hochfrequenz-Oszillator 30 hat eine Höhe von zirka 725 µm und einen auf die gewünschte Resonatorfrequenz 122,3 GHz abgestimmten Radius von 242 µm.

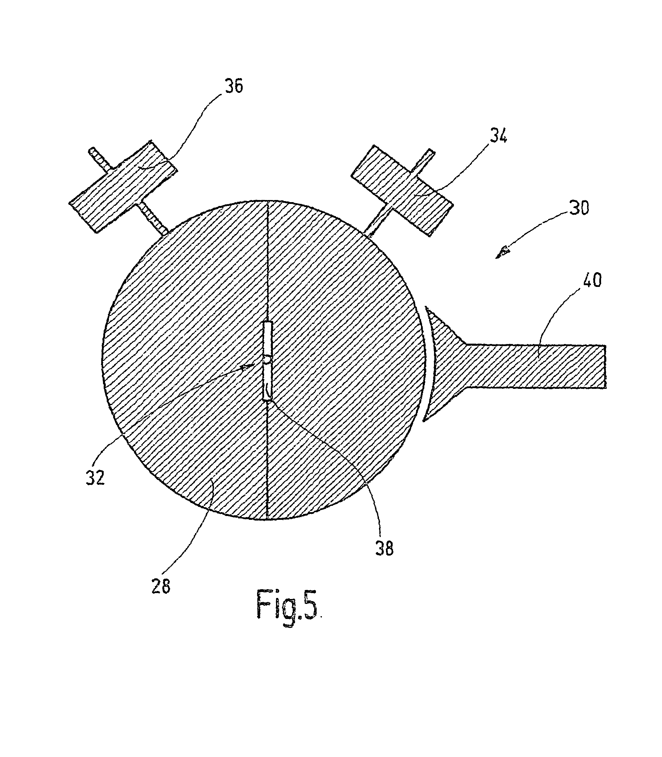

Die Figur 5 zeigt eine Draufsicht auf einen Hochfrequenz-Oszillator 30, wie er für die Erzeugung eines Sendesignals im Mikrowellenbereich benötigt wird. Neben dem Resonator 24 umfasst der Hochfrequenz-Oszillator 30 eine Impatt-Diode 32, die über zwei Tiefpassfilter 34, 36 mit Spannung versorgt wird. Die Impatt-Diode 32 sitzt in der Ausnehmung 38 der Ankopplungsscheibe 28 und ermöglicht die Verbindung zu einer in die Schicht 12 integrierten Mikrostreifenleiter-Schaltung (nicht dargestellt). Die Ausnehmung 38 kann verschiedene Konturen aufweisen, ist aber in jedem Falle in ihrer Dimensionierung so gering ausgelegt, dass sie keinen Einfluss auf die HochfrequenzEigenschaften des Oszillators 30 hat. Die erzeugte Sendeenergie des Hochfrequenz-Oszillators 30 wird über ein Koppelelement 40, mit der Ankopplungsscheibe angepasster Ausformung, in die umgebende Mikrostreifenleiter-Schaltung eingespeist. Für den Fall eines spannungsgesteuerten Oszillators wird zusätzlich zur Impatt-Diode 32 eine ebenfalls nicht dargestellte Varaktor-Diode am Rande der Ankopplungsscheibe 28 implantiert.

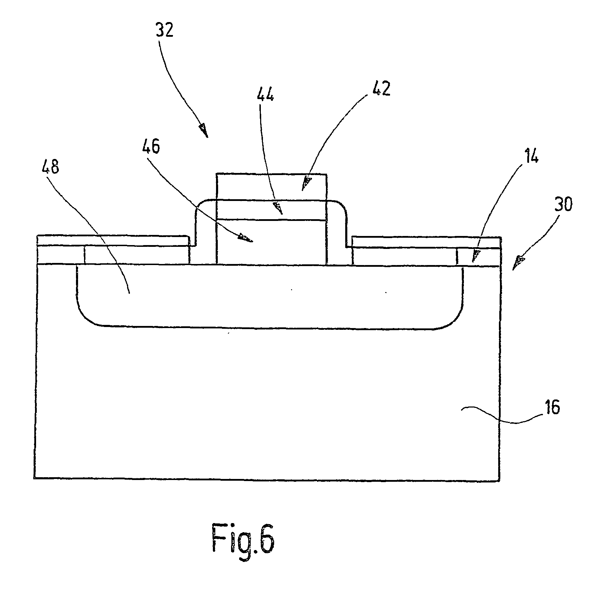

Die Figur 6 zeigt einen Querschnitt durch die Halbleiterschaltung 10 im Bereich der Impatt-Diode 32. Derartige Dioden sind bekannt, so dass auf eine detaillierte Beschreibung der Funktionsweise an dieser Stelle verzichtet wird. Aufeinander folgend umfasst die Impatt-Diode 32 eine Aluminiumschicht 42, eine p⁺-dotierte Siliziumschicht 44, eine epi-Siliziumschicht 46 und eine n⁺-dotierte Schicht 48.

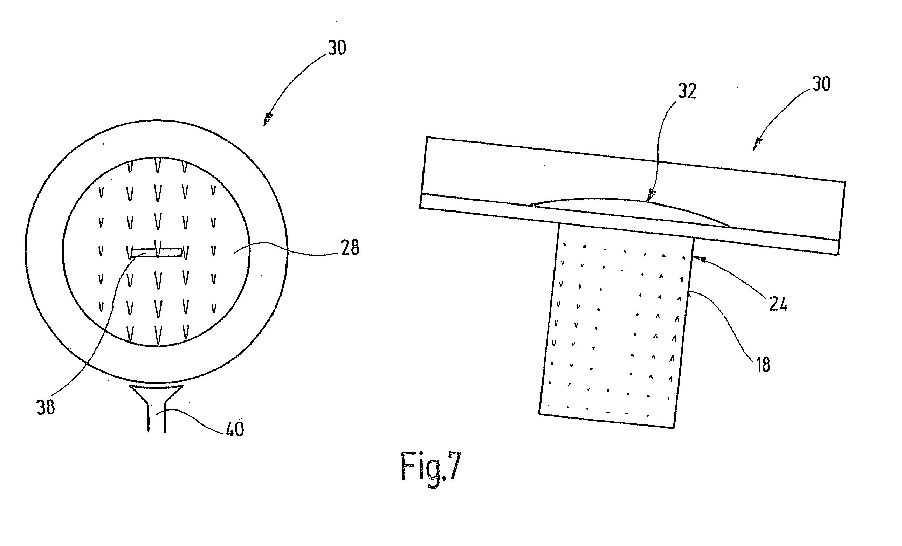

Der Hochfrequenz-Oszillator 30 kann im für Hochfrequenzanregungen besonders günstigen TE₁₁₁-Mode betrieben werden. In der Figur 7 ist ein Verlauf der elektrischen (links - Draufsicht)und magnetischen (rechts - Schnittdarstellung) Feldlinien im Anregungsfall des TE₁₁₁-Modes dargestellt.

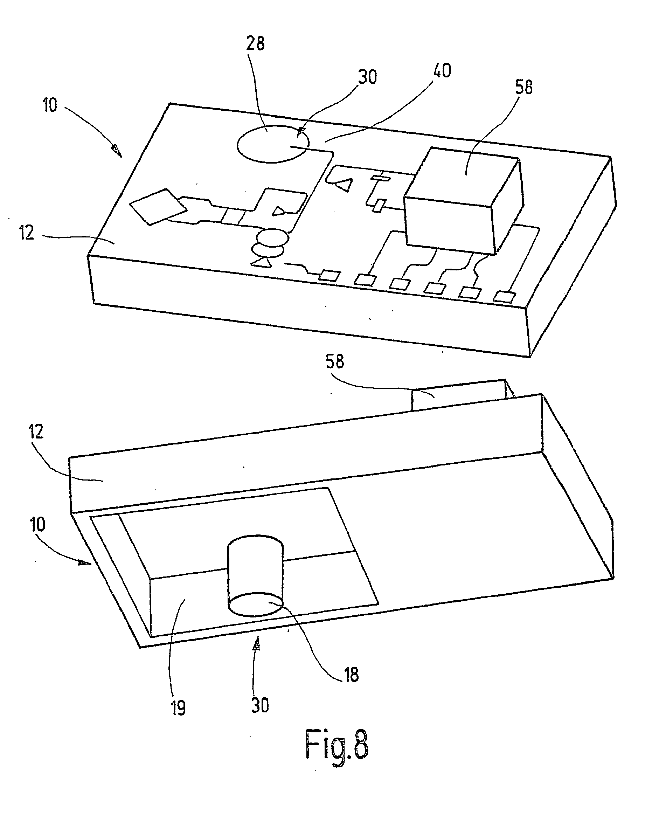

Figur 8 zeigt zwei perspektivische Ansichten auf eine Halbleiterschaltung 10 (Chip) mit integriertem Hochfrequenz-Oszillator 30, die für Radarsysteme zur Abstandsmessung im Kraftfahrzeugumfeld geeignet ist. Zur Verbesserung der Frequenzstabilisierung ist eine aktive Oszillatorschaltung 58 - hier in Form einer zusätzlichen GaAs-Halbleiterschaltung, die beispielsweise in Flip-Chip-Technik montiert wird - vorhanden. Alternativ kann die aktive Oszillatorschaltung 58 durch einen leitend aufgeklebten, diskreten Einzeltransistor verwirklicht werden. Die in diesem Fall erforderliche Anpassungsschaltung kann in Koplanar- und in Nikrostreifenleiter-Technik ebenfalls in die Schicht 12 der Halbleiterschaltung 10 integriert werden. Besonders in der Druntersicht wird die Ausbildung des in den Freiraum 19 einkragenden Zylinders 18 deutlich.

## Patentansprüche

1. Hochfrequenz-Oszillator für eine integrierte Halbleiterschaltung, **dadurch gekennzeichnet, dass** der Hochfrequenz-Oszillator (30) Bestandteil der Halbleiterschaltung (10) ist, die eine erste Siliziumschicht (12), eine sich anschließende Siliziumdioxidschicht (14) und eine nachfolgende weitere Siliziumschicht (16) umfasst wobei der Hochfrequenz-Oszillator (30)
(a) einen Resonator (24) mit einem in der weiteren Siliziumschicht (16) angeordneten, metallisierten Zylinder (18) aus Silizium und eine den Zylinder (18) im Bereich der ersten Siliziumschicht (12) überdeckende Ankopplungsscheibe (28) sowie
(b) eine über eine Ausnehmung (38) der Ankopplungsscheibe (28) mit dem Zylinder (18) des Resonators (24) in Verbindung stehende Impatt-Diode (32) umfasst.

2. Hochfrequenz-Oszillator nach Anspruch 1, **dadurch gekennzeichnet, dass** der Hochfrequenz-Oszillator (30) so dimensioniert ist, dass er eine feste Frequenz im Bereich von 80 bis 500 GHz, insbesondere von 100 bis 150 GHz, erzeugt.

3. Hochfrequenz-Oszillator nach Anspruch 1 oder 2, **dadurch gekennzeichnet, dass** der Zylinder (18) des Resonators (24) von einer Aluminiumschicht (20) bedeckt ist.

4. Hochfrequenz-Oszillator nach einem der Ansprüche 1 bis 3, **dadurch gekennzeichnet, dass** die Ankopplungsscheibe (28) des Resonators (24) so dimensioniert ist, dass an deren Rand keine Sendeenergie austreten kann.

5. Hochfrequenz-Oszillator nach einem der Ansprüche 1 bis 4, **dadurch gekennzeichnet, dass** der Hochfrequenz-Oszillator (30) spannungsgesteuert ist und eine Varaktor-Diode am Rand der Ankopplungsscheibe (28) implantiert ist.

6. Hochfrequenz-Oszillator nach einem der Ansprüche 1 bis 5, **dadurch gekennzeichnet, dass** eine Spannungsversorgung der Impatt-Diode (32) über zwei Tiefpassfilter (34, 36) erfolgt.

7. Hochfrequenz-Oszillator nach einem der Ansprüche 1 bis 6, **dadurch gekennzeichnet, dass** die erste Siliziumschicht (12) als Trägersubstrat für eine darauf angeordnete Mikrostreifenleiter-Schaltung dient.

8. Hochfrequenz-Oszillator nach einem der Ansprüche 1 bis 7, **dadurch gekennzeichnet, dass** eine Einspeisung der erzeugten Senderenergie des Hochfrequenz-Oszillators (30) in die umgebende Mikrostreifenleiter-Schaltung über ein Koppelelement (40) erfolgt.

9. Verwendung des Hochfrequenz-Oszillators nach einem der Ansprüche 1 bis 8, **dadurch gekennzeichnet, dass** der Hochfrequenz-Oszillator (30) Bestandteil eines Sensors zur Entfernungsmessung ist.

10. Verwendung nach Anspruch 9, **dadurch gekennzeichnet, dass** der Sensor in einem Kraftfahrzeug zur Toten-Winkel-Erkennung, Precrash- und Sidecrash-Erkennung, Einparkhilfe und Abstandsmessung Einsatz findet.

## Claims

1. High-frequency oscillator for an integrated semiconductor circuit, **characterized in that** the high-frequency oscillator (30) is a component of the semiconductor circuit (10) which comprises a first silicon layer (12), a following silicon dioxide layer (14) and a following further silicon layer (16), wherein the high-frequency oscillator (30) comprises
(a) a resonator (24) with a metallized cylinder (18) of silicon arranged in the further silicon layer (16) and a coupling disc (28) covering the cylinder (18) in the area of the first silicon layer (12), and
(b) an impatt diode (32) connected to the cylinder (18) of the resonator (24) via a recess (38) in the coupling disc (28).

2. High-frequency oscillator according to Claim 1, **characterized in that** the high-frequency oscillator (30) is dimensioned in such a manner that it generates a fixed frequency in the range from 80 to 500 GHz, particularly from 100 to 150 GHz.

3. High-frequency oscillator according to Claim 1 or 2, **characterized in that** the cylinder (18) of the resonator (24) is covered by a aluminium layer (20).

4. High-frequency oscillator according to one of Claims 1 to 3, **characterized in that** the coupling disc (28) of the resonator (24) is dimensioned in such a manner that no transmit energy can emerge at its edge.

5. High-frequency oscillator according to one of Claims 1 to 4, **characterized in that** the high-frequency oscillator (30) is voltage-controlled and a varactor diode is implanted at the edge of the coupling disc (28).

6. High-frequency oscillator according to one of Claims 1 to 5, **characterized in that** a voltage is supplied to the impatt diode (32) via two low-pass filters (34, 36).

7. High-frequency oscillator according to one of Claims 1 to 6, **characterized in that** the first silicon layer (12) is used as supporting substrate for a microstrip conductor circuit arranged thereon.

8. High-frequency oscillator according to one of Claims 1 to 7, **characterized in that** the generated transmitter energy of the high-frequency oscillator (30) is fed into the surrounding microstrip conductor circuit via a coupling element (40).

9. Use of the high-frequency oscillator according to one of Claims 1 to 8, **characterized in that** the high-frequency oscillator (30) is a component of a sensor for range measuring.

10. Use according to Claim 9, **characterized in that** the sensor is used in a motor vehicle for dead-angle recognition, pre-crash and side crash recognition, parking aid and distance measuring.

## Revendications

1. Oscillateur haute fréquence pour un circuit semi-conducteur intégré,
**caractérisé en ce que**
l'oscillateur haute fréquence (30) est un composant du circuit semi-conducteur (10) qui comporte une première couche de silicium (12), une couche de dioxyde de silicium (14) adjacente et une autre couche de silicium suivante (16), l'oscillateur haute fréquence (30) comportant :
(a) un résonateur (24) ayant un cylindre (18) en silicium métallisé, disposé dans l'autre couche de silicium (16) et un disque de couplage (28) recouvrant le cylindre (18) au niveau de la première couche de silicium (12) ainsi qu'
(b) une diode à avalanche (32) en liaison avec le cylindre (18) du résonateur (24) par l'intermédiaire d'un évidement (38) du disque de couplage (28).

2. Oscillateur haute fréquence selon la revendication 1,
**caractérisé en ce que**
l'oscillateur haute fréquence (30) est dimensionné de manière à produire une fréquence fixe de l'ordre de 80 à 500 GHz, en particulier de 100 à 150 GHz.

3. Oscillateur haute fréquence selon la revendication 1 ou 2,
**caractérisé en ce que**
le cylindre (18) du résonateur (24) est recouvert d'une couche d'aluminium (20).

4. Oscillateur haute fréquence selon l'une quelconque des revendications 1 à 3,
**caractérisé en ce que**
le disque de couplage (28) du résonateur (24) est dimensionné de manière à ce qu'aucune énergie d'émission ne puisse sortir de son bord.

5. Oscillateur haute fréquence selon l'une quelconque des revendications 1 à 4,
**caractérisé en ce qu'**
il est asservi en tension et une diode varactor est implantée sur le bord du disque de couplage (28).

6. Oscillateur haute fréquence selon l'une quelconque des revendications 1 à 5,
**caractérisé en ce que**
la diode à avalanche (32) est alimentée en tension par deux filtres passe-bas (34, 36).

7. Oscillateur haute fréquence selon l'une quelconque des revendications 1 à 6,
**caractérisé en ce que**
la première couche de silicium (12) sert de support pour un circuit microbande disposé dessus.

8. Oscillateur haute fréquence selon l'une quelconque des revendications 1 à 7,
**caractérisé en ce que**
l'énergie d'émission générée de l'oscillateur haute fréquence (30) est introduite dans le circuit microbande environnant par un élément de couplage (40).

9. Utilisation de l'oscillateur haute fréquence selon l'une quelconque des revendications 1 à 8,
**caractérisée en ce qu'**
il (30) fait partie d'un capteur de mesure de distances.

10. Utilisation selon la revendication 9,
**caractérisée en ce que**
le capteur est utilisé dans un véhicule automobile pour la détection d'angles morts, la détection prévisionnelle de chocs et la détection de chocs latéraux, l'aide au stationnement et la mesure des distances.
